# EUROPEAN PATENT APPLICATION

(11) **EP 0 571 727 A1**
(43) Date of publication of application: **01.12.1993**
(21) Application number: 93104231.1
(22) Date of filing: 16.03.1993
(51) Int. Cl.: H01J 37/317

(54) **Apparatus and method for focussed ion beam deposition by controlling beam parameters**

(30) Priority: 23.04.1992 US 872481
(71) Applicant: INTERNATIONAL BUSINESS MACHINES CORPORATION, Armonk, NY 10504 (US)
(72) Inventor: Blauner, Patricia G., Sandy Hook, Connecticut 06482 (US); Dubner, Andrew David, Ossining, N.Y. 10562 (US); Levin, James Peter, Jericho, Vermont, 05465 (US); Longo, Peter Paul, Hopewell Junction, New York 12533 (US); Mauer IV, John Lester, South Kent, Connecticut 06785 (US); Wagner, Alfred, Brewster, New York 10509 (US)
(74) Representative: Schäfer, Wolfgang, Dipl.-Ing.

(57) **Abstract**

The disclosure describes a method and structure to control the focussed ion beam induced deposition of material. The structure includes a focussed ion beam which is directed onto a target surface. The ion beam is deflected to locations on the target surface and is blanked and unblanked at desired intervals. The deflection and blanking are controlled by timing means in response to computer signals. A precursor gas is adsorbed into the target surface and the ion beam selectively decomposes the adsorbed gas along a desired shape to provide material deposition. The shape of the deposition is specified by a number of successive beam spots. The spots can be specified to overlap adjacent spots if desired for better edge resolution, but in general, the optimum yield is obtained without overlap. The dwell time for each spot is set to provide high net yield for the deposited material. The beam is stepped to each position in the shape and the deposition is repeated. Alternatively, the beam could be moved in sequential line scans either stepwise or continuously between spots, but spot by spot deflection allows better control of the feature shape. After completing all the spots in the pattern, the process is repeated until a film of material of the desired thickness is built up.

## Description

The present invention relates to the deposition of material on a surface by an ion beam, and more particularly to a method and apparatus for controlling the deposition by controlling the ion beam scanning.

U.S. Patent 4,876,112, issued October 24, 1989, entitled METHOD AND APPARATUS FOR FORMING METAL FILM ON SUBSTRATE describes a technique wherein metal film is deposited on a substrate from metal hexacarbonyl vapors in the presence of an ion beam. This reference does not disclose a scan method (refresh and dwell) and the deflection speed necessary for controlled deposition using a high current density focused ion beam.

U.S. Patent 4,929,839, issued May 29, 1990, entitled IONIC BEAM FOCUSING COLUMN FOR IONIC IMPLANTATION discloses an ionic beam column in which the length of the column can be easily changed together with the distance between column and workpiece, comprises an ionic source of high intensity containing many types of ions; a first electrode near the source for extracting certain ions; a target onto which the beam is focused and moved; a beam defining aperture determining the acceptance angle of ions passing into the column; upper focusing means for focusing the ionic source into a central beam point where the beam exit voltage is constant relative to the ionic source and essentially raised above the beam entry voltage independent of the changes of the beam entry voltage; lower focusing means for building a central beam point on the surface of the target where beam entry voltage is constant relative to the ionic source and equal to the exit voltage from the upper focusing means and the beam exit voltage is larger, smaller or equal to the exit final energy; to the requirements of the beam final energy; a constant high voltage casing between exit of upper focusing means and inlet of lower focusing means, where the beam voltage is constant relative to the ionic source and equal to the exit voltage from the upper focusing means; and main deflector for moving the beam over the surface. Ion beam deposition is not disclosed, only a specific ion beam column optical design.

U.S. Patent 4,958,074, issued September 18, 1990, entitled X-RAY, ELECTRON OR ION BEAM LITHOGRAPHY MASK INSPECTION SYSTEM, discloses an inspection system for a lithography mask having opaque and transparent zones; uses a precisely focused electron or ion inspection beam above a coordinate or rotary table supporting the mask in alignment with an aperture for passage of the inspection beam onto an emitter surface exhibiting secondary radiation. The secondary radiation resulting from the incident beam passing through the transparent zones of the mask is detected by a radiation detector coupled to an image storage device. This reference does not teach ion beam induced deposition.

U.S. Patent 4,851,097, issued July 25, 1989, entitled PHOTO-MASK PATTERN FILM REPAIRING APPARATUS, discloses a system wherein an ion source of liquid metal gallium produces ions which are formed into a beam by a focusing lens and objective lens. The focused beam is scanned across the photo-mask by a scanning electrode. Secondary charged particles emitted from the irradiated surface are detected and the signal formed is A-D converted and displayed. An X-Y stage is adjusted to bring the section of film to be repaired within the scanning range of the ion beam. The etchant gas is directed through a nozzle from a gas cylinder. This reference does not teach ion induced deposition.

U.S. Patent 4,924,104, issued May 8, 1990, entitled ION BEAM UNIT FOR SUBSTRATE REPAIR, teaches an ion beam system that uses the output of an ion source which is passed through a mask that has a circular aperture. The emission is accelerated by an immersion lens to provide sufficient energy on the substrate under repair. After passing through the immersion lease, the beam is deflected and is passed to a projection lens for focusing onto the surface of the substrate. The substrate is mounted on a coordinate table that allows precise positioning to be obtained.

U.S. Patent 4,639,301, issued January 27, 1987, entitled FOCUSED ION BEAM PROCESSING discloses an ion beam processing device comprises an ion beam and an electron beam source. The ion beam source produces a finely focused beam which impinges at a point on a substrate surface in a predetermined surface plane. The electron beam source directs the electron beam around the ion beam and neutralises any surface charge caused by the ion beam. Means for detecting secondarily emitted particles are included in the device and its signals control the ion and electron beam sources causing them to etch the surface plane as required. This reference does not teach ion beam induced deposition.

Japanese Patent J60245227, issued December 5, 1985, entitled PATTERN FILM FORMING METHOD, discloses a technique to correct white spot defects of an X-ray mask and to repair a conductive pattern on an LSI substrate by employing vapor of gold, molybdenum, palladium, tantalum or tungsten compound. Compound vapor sprayed on the substrate to be deposited, evaporates after it has stayed there for any time determined by the substrate temperature and the kind of the compound. At this time, a deposited compound layer is produced at the place where the compound has been sprayed. Irradiating laser or particle beam onto the deposited compound layer results in decomposition or combination of the compound to form a pattern film which is deposited increasingly as time proceeds. By employing molybdenum, palladium or tungsten compound as the said compound, an X-ray mask, which has sufficient X-ray blocking ability by a film thickness of about 1 µm, can be provided.

In focused ion beam deposition, a linear relationship exists between the number of molecules adsorbed on the surface and the number of atoms deposited per incident ion. However, a focused ion beam has a sufficiently high current density that all or most of the adsorbed molecules can be decomposed during the period that the beam dwells on a particular spot. Because physical sputtering is occurring as well, the result can be little net deposition or even removal of part of the surface. Generally, short dwell times are required for net deposition of material. Thick deposits can be formed by repetitively scanning the feature. However, even if the dwell time is reduced so that net deposition occurs, the thickness of the deposit will vary as a function of the size of the feature. To maintain a constant deposition rate, sufficient time must be allowed at the end of each scan for readsorption of the precursor gas. Present ion beam systems do not recognize the importance of the time given for readsorption and do not independently control this refresh time.

An object of the present invention is to provide a method and apparatus to control the focused ion beam induced deposition of material on a surface. The shape of the deposition is specified by a number of spaced ion beams spots. The spots can be specified to overlap adjacent spots, if desired, for better shape edge resolution, but, in general, the optimum yield is obtained without overlap. The dwell time for each spot on the surface is set to provide high net yield for the deposited material. The beam is then stepped to the next position in the shape and the deposition is repeated. The refresh time, or time allowed between successive passes through the shape, is set to provide adequate time for readsorption of the precursor gas. Alternatively, the beam could be moved in sequential line scans either stepwise or continuously between spots, but spot by spot deflection allows better control of the feature shape.

Ways of carrying out the invention are described in detail below with reference to drawings showing only specific embodiments in which:
Fig. 1 is a schematic illustration of a curve representing the net deposition of material on a surface as a function of ion beam irradiation time (dwell time) during the ion beam induced deposition process. At long times, the coverage of the adsorbed gas is depleted and material is lost.
Fig. 2 is a schematic illustration of a shape or pattern of material deposited on a surface by an ion beam specified by a plurality of beam spots.
Fig. 3 is a schematic illustration of material deposition and precursor coverage on a surface with respect to time. Dwell is the amount of time the ion beam irradiates the surface during a single cycle while refresh is the amount of time between successive irradiations.
Fig. 4 presents an equation which relates system parameters to deposition yield. The parameter values listed are for deposition using dimethyl-gold-hexafluoroacetylacetonate and a 20 keV Ga ⁺ focused ion beam.
Fig. 5 is a schematic illustration of an ion beam column structure which may be used in the present invention.
Fig. 6 is a schematic block diagram of the timing control of the present invention.

Focused ion beams are used to induce the deposition of material on a surface. The source of the material is a precursor gas adsorbed on the surface and which is decomposed by a coincident ion beam to deposit the material on the surface. However, the incident ion beam also removes deposited material through physical sputtering. Thus, the net yield of the deposited material (number of atoms deposited per incident ion) is reduced by the competition between sputtering and decomposition. Present ion beam systems and the processes imbedded in them do not control net deposition rates because they do not control the relevant system parameters. This results in deposition rates dependent on feature size and in poor edge definition.

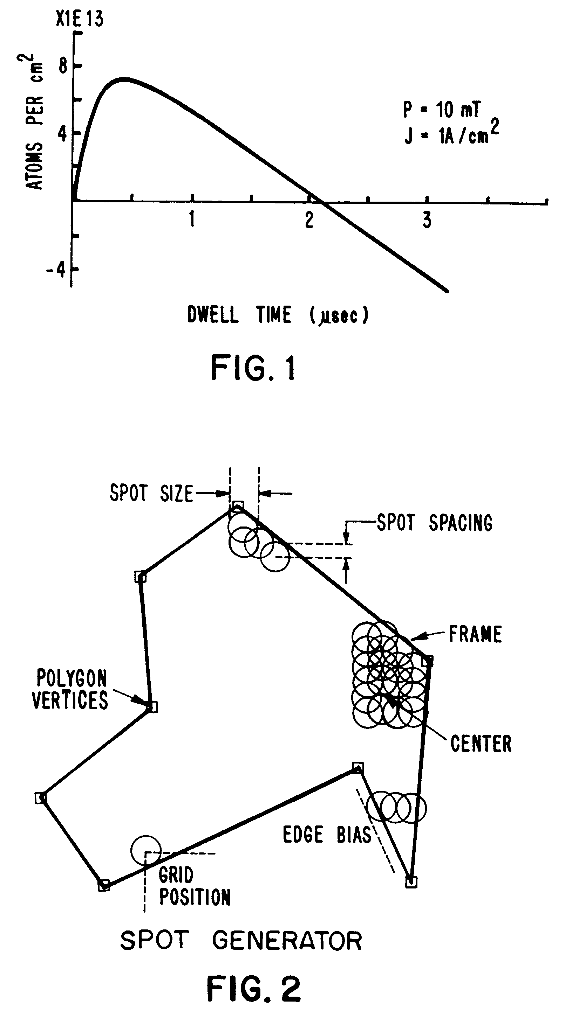

It is known that a linear relationship exists between the number of molecules adsorbed on the surface and the number of atoms deposited per incident ion, A.D. Dubner and A. Wagner, "The role of gas adsorption in ion-beam-induced deposition of gold", J. Appl. Phys. 66 (2), p. 870-4 (1989). However, a focused ion beam has a sufficiently high current density that all or most of the adsorbed molecules can be decomposed during the period that the beam dwells on a particular spot. Because physical sputtering is occurring as well, the result can be little net deposition or even removal of part of the surface. An illustration of the net deposition of material on a surface as a function of dwell time is shown in Fig 1. As shown, short dwell times are required for net deposition of material.

However, even if the dwell time is reduced so that net deposition occurs, the net yield of deposited material will vary as a function of the size of the feature. To maintain a constant deposition rate, sufficient time must be allowed at the end of each scan for readsorption of the precursor gas. Present ion beam systems do not recognize the importance of the time given for readsorption and do not independently control this refresh time.

The present invention provides a method and structure to control the focused ion beam induced deposition of material. The shape of the deposition is specified by a number of beam spots as shown in Fig. 2. The spots can be specified to overlap adjacent spots if desired for better edge resolution, but in general, the optimum yield is obtained without overlap. The dwell time for each spot is set to provide high net yield for the deposited material. Typically, the dwell time for known precursors is of the order of 1 µsec or less. The beam is stepped to the next position in the shape and the deposition is repeated. Alternatively, the beam could be moved in sequential line scans either stepwise or continuously between spots, but spot by spot deflection allows better control of the feature shape. After completing all the spots in the pattern, the process is repeated until a film of the desired thickness is built up.

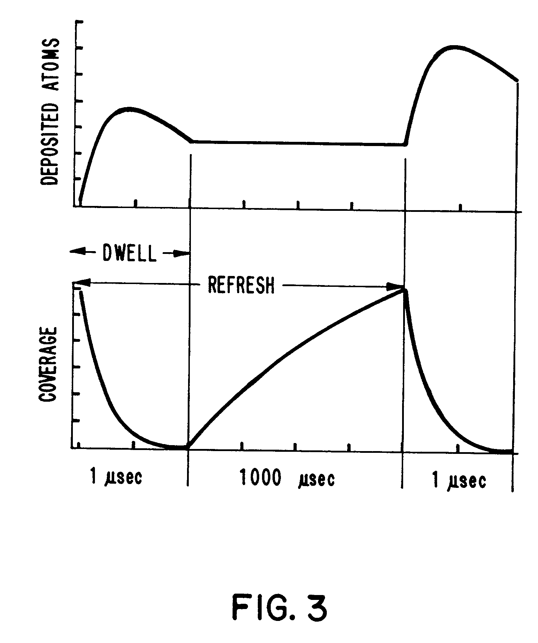

For all shapes, the time required for readsorption depends on the precursor gas and its adsorption characteristics on the deposited film. For large shapes, the refresh time required for adequate readsorption may be less than the writing time per scan. In this case no extra time need be allowed between passes through the spots in the pattern. However, for small shapes, the beam must be turned off until the initial spot readsorbs enough gas to provide for optimum deposition in the next cycle. Typically, the refresh time for known precursors is 1 msec or more. Figure 3 illustrates a typical deposition cycle, showing both the net accumulation of deposited atoms (top) and the cycling of the absorbed coverage of the precursor gas.

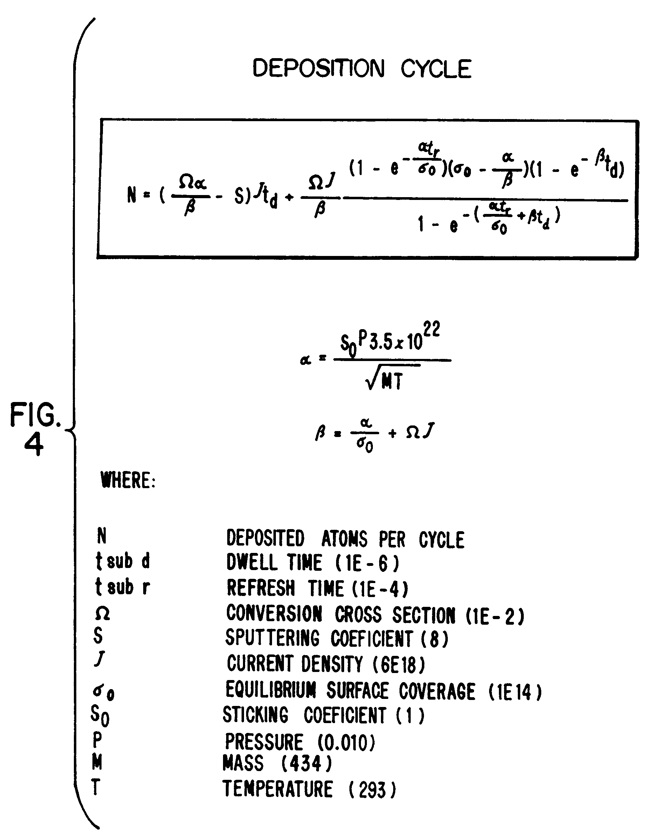

By using optimum dwell times and sufficient refresh times, the net deposition rate can be made independent of the size of the feature. Alternatively, specific dwell and refresh times may be chosen so as to shape the deposit by varying the net deposition or change the characteristics of the deposited film. Also, the temperature of the substrate may be changed to effect the adsorption of the precursor gas and thus the optimum dwell and refresh times. Edge resolution is affected by the Gaussian shape of the ion beam. By controlling dwell and refresh times, edge resolution can be maximized to reflect the beam profile. An equation which relates system parameters to deposition yield has been developed and is shown in Fig. 4. This equation has been verified and utilized for quantitative estimates of the deposition yield (rate), process optimization and modelling.

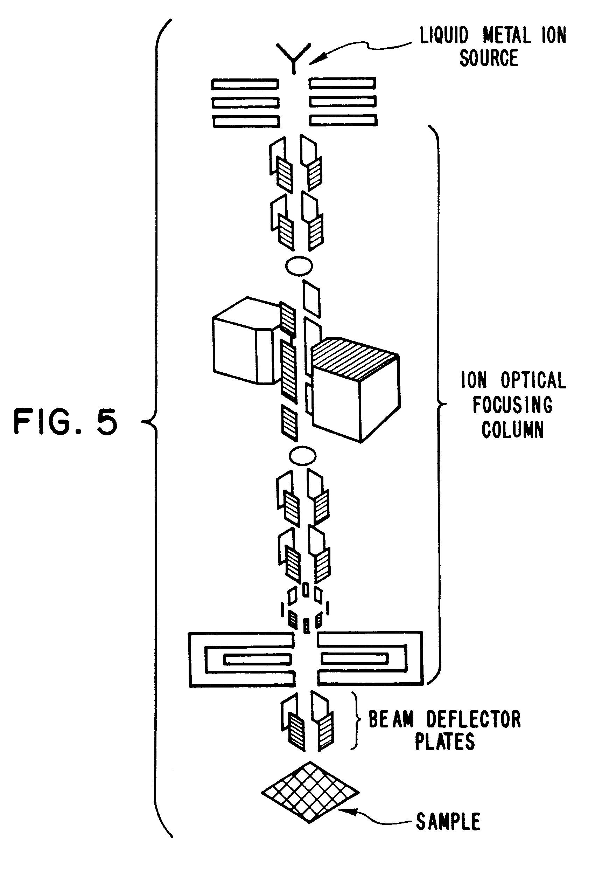

The present invention also provides a focused ion beam structure that incorporates independent control of dwell and refresh time. The structure shown in Fig. 5 includes a focussed ion beam column in combination with high speed deflection means, spot by spot beam blanking means, a gas feed means, and timing control means.

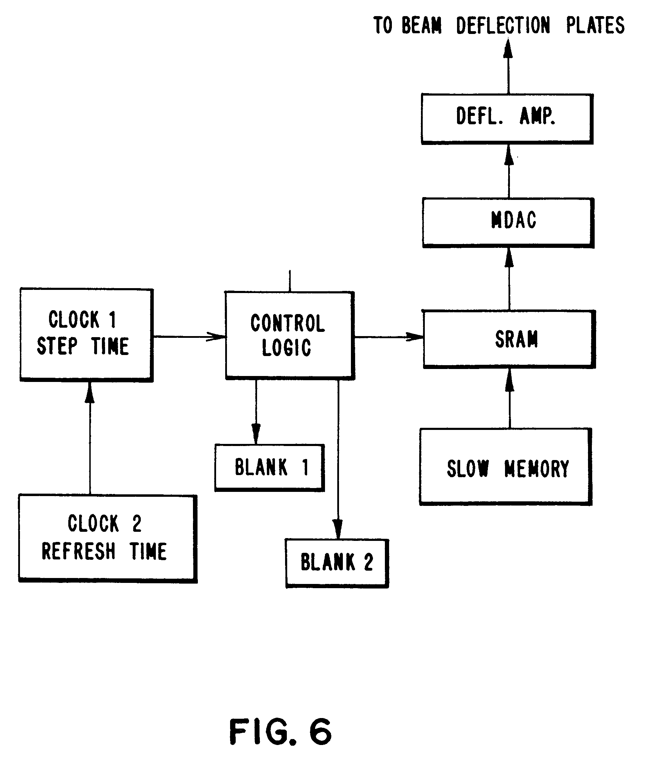

A typical deposition operation would be done as follows:
1. The uses specifies to the computer the position, shape and size of the deposit to be made.
2. The precursor gas introductory system is initiated. Gas flow is begun and the gas feed is positioned sufficiently close to the sample to provide readsorption during the refresh cycle.
3. The computer calculates the spot placement by dividing up the pattern to be written into individual spot placements with specified spacing and bias as shown in Fig. 2. These placements are expressed in terms of input voltages to the deflection amplifier.
4. The computer calculates the required number of passes through the pattern of spots to deposit the thickness of material based on the specified refresh and dwell times.
5. The spot placements are loaded into fast memory (SRAM).
6. The spot placements are clocked out to a digital to analog voltage converter and from there to the deflection amplifier. The amplified voltages are then fed to the deflection plates on the focused ion beam system to control the beam position (Fig. 6).

The rate at which these signals are clocked is determined by the timing control. This includes a clock to control the refresh time and a clock to control the spot stepping time. Alternatively, one master clock may be used from which the dwell and refresh time are derived. The dwell time at each spot is controlled by either of two techniques. In the first technique, the beam is continuously unblanked during shape writing and the dwell time is determined by the spot stepping time. In the second method, the beam is blanked during spot stepping and is briefly unblanked at each spot position for the required dwell time.

## Claims

1. A system for ion beam induced deposition of material on a target comprising:
an ion beam column structure including an ion beam source,
means proximate to said ion beam in said column for focussing said ion beam to provide a beam having a small circular cross-section,
a deflection means in said column for positioning said ion beam at desired locations on a target surface,
a blanking means in said column for preventing said ion beam from reaching said target surface at desired time intervals, and for permitting said ion beam to reach said target surface during unblanked time intervals,
a gas feed means for providing precursor gas containing material to said target surface for adsorbtion,
timing control means including a clock means for controlling the time period the said ion beam is blanked and for controlling the time that the said ion beam dwells at a location on said target surface,
and computer means connected to said deflection means and said timing control means for providing control signals for directing said ion beam onto successive locations on said target surface for predetermined dwell times at each location for decomposing said absorbed gas at said successive locations and depositing said material at said target surface.

2. The system for ion beam induced deposition of material on a target surface according to claim 1 wherein said control signals provided from said computer means to said deflection and timing control means direct said ion beam to scan along a predetermined path of successive locations on said target surface to form a pattern of deposited material from said absorbed precursor gas.

3. The system for ion beam induced deposition of material on a target surface according to claim 1 or 2 wherein said precursor gas is readsorbed into said target surface during a refresh time period after said directed scan of said ion beam, and wherein said computer means provides control signals to said deflection means and said timing means to repeat said scan pattern to provide additional deposition of material at said predetermined locations after said refresh time period.

4. The system for ion beam deposition of material on a target surface according to any of the preceding claims 1 or 3 wherein said computer means provides control signals to said deflection means and said timing means wherein said ion beam is unblanked between deflections to successive locations along said pattern on said target surface.

5. The system for ion beam deposition of material on a target surface according to any of the preceding claims 1 to 4 wherein said computer means provides control signals to said deflection means and said timing means wherein said ion beam is blanked between deflections to successive locations along said pattern on said target surface and is unblanked at said locations.

6. A method of depositing material from a precursor gas absorbed on the surface of a target by directing a focussed ion beam onto said target surface for decomposing said absorbed precursor gas comprising the steps of:
step 1 providing a precursor gas for adsorbtion onto a target surface;
step 2 directing a focussed ion beam onto said target surface for decomposing said adsorbed precursor gas on said target surface and depositing material from said decomposed precursor gas onto said target surface;
step 3 deflecting said focussed ion beam onto a plurality of successive spots on said target surface to provide a pattern of deposited material;
step 4 further deflecting said focussed ion beam onto said target surface along said plurality of successive spots after a refresh time interval sufficient for said precursor gas to be readsorbed into said target surface, to provide additional deposition of material along said pattern.

7. The method of depositing material from a precursor gas according to claim 6 further including the steps of:
controlling the time period that the ion beam dwells at said successive spots on said target surface to control said amount of deposition of material there at controlling the deflection of said ion beam said successive spots on said target surface to form a desired pattern from said spots of deposited material.

8. The method of depositing material from a precursor gas according to claim 6 or 7 further including the step of blanking said ion beam to prevent said ion beam from reaching said target surface of selected times.

9. The method of depositing material from a precursor gas according to any of the preceding claims 6 to 8 wherein said ion beam is blanked during deflections between successive spots.
